Europäisches Patentamt

(19)     European Patent Office

Office européen des brevets

(11)     EP 0 919 820 A2

(12)     **EUROPEAN PATENT APPLICATION**

(43) Date of publication:
02.06.1999 Bulletin 1999/22

(51) Int. Cl.⁶: **G01R 31/28**

(21) Application number: 98120161.9

(22) Date of filing: 28.10.1998

(84) Designated Contracting States:
AT BE CH CY DE DK ES FI FR GB GR IE IT LI LU
MC NL PT SE
Designated Extension States:
AL LT LV MK RO SI

(30) Priority: 30.10.1997 JP 298316/97

(71) Applicant:
Nidec-Read Corporation
Uji-city, Kyoto 611-0041 (JP)

(72) Inventors:
• Yamashita, Munehiro
Uji-city, Kyoto 611-0041 (JP)
• Kaida, Mitio
Uji-city, Kyoto 611-0041 (JP)

(74) Representative: HOFFMANN - EITLE
Patent- und Rechtsanwälte
Arabellastrasse 4
81925 München (DE)

(54)     **Circuit board testing apparatus and method**

(57)     To conduct a continuity test in a short period of time using a moving head type testing apparatus a probe is made to contact one end of the test wiring of a circuit board (32), with a head (52) electrostatically coupled to the other end of the wiring, a pulse-like DC voltage is suplied from a signal source (46). Simultaneously with a switch section (SWp) turning on, the maximum voltage is applied to the test wiring. If a detection signal is below a specified value a computer (44) will determine this as "openning" or "shorting". Further, a tip (52a) of the head (52) may touch the circuit board (32) through an insulating sheet (33), so that the tip (52a) is kept away from each pad of a pad section (38) in the circuit board (32) at a fixed distance equivalent to the thickness of the insulating sheet (33). Thus a continuity test may be performed in a non-contact manner by moving the head (52) only along the X and Y directions without additional movement along the Z-direction.

Fig. 1

## Description

[Detailed Description of the Invention]

[Field of the Invention]

The present invention relates to a circuit board testing apparatus, and in particular to a wiring test using electrostatic capactiy according to the preamble of claim 1.

In the Japanese Patent Application Laid Open Publication No. 4-248477, there is described a printed circuit board testing apparatus using a filying probe. Such a testing apparatus is equipped with the X- and Y-axis servo sections that drive an X-Y table on which a circuit board to be tested is to be mounted, and a Z-axis servo section that drives a probe head. To be more specific, the testing apparatus operates to test a desired pattern for continuity and shortcuts by moving said X-Y table so that the probe head is positioned on the pad section of the pattern, and also by driving the Z-axis servo section so that the probe head contacts said pattern. When said pattern is tested, the Z-axis servo section drives the probe head to leave the pattern. Then the X-Y-table is moved such that the probe head is positioned on the pad section of another pattern which is to be tested subsequently.

This enables circuit boards of any kind to be tested by changing only the position data of the pad section.

Nevertheless, the following problems exist with respect to the known circuit board testing apparatus.

When moving the probe head from one pad to another, the X-Y table cannot be moved unless the probe head is kept away from the contacted pad. Therefore, supposing that the testing of one printed pattern requires e.g. several milliseconds for the Z-axis transfer since several thousands of tests are conducted for a single circuit board several tens of seconds will be required for the Z-axis transfer during the test of only a single circuit board.

Further, allowing the probe head tip to contact the pad section leads to scars at the pad section. In particular, becasue the finely pitched pad section is small in size the scars have a great adverse effect on the pad section.

Therefore, an object of the present invention is to provide a printed circuit board testing apparatus and related method enabling quick wiring testing without causing damage to the wiring.

This object is achieved with a circuit board testing apparatus set forth in claim 1. The first terminal is coupled in a non-contact manner to either end of the test wiring of the circuit board to be tested. The transfer means transfers the first terminal over the surface on which the test wiring of said circuit board to be tested is formed, while retaining the non-contact condition. The test signal suply means supplies a test signal to the other end of the non-contact coupled test wiring. The determination means determines the test wiring of circuit board to be tested, for continuity and short based on the detection signal detected from the non-contact coupled test wiring. The present invention therefore eliminates the need to move the first terminal towards and away from the circuit board surface, thus reducing the testing time. Furthermore, since the terminal at one end can be determined for continuity and short in a non-contact manner no risk of flaw arises on the terminal at said one end.

A further preferred embodiment of the circuit board testing apparatus is set forth in claim 2. Here, an insulating sheet is provided between the first terminal and the circuit board to be tested. Therefore, the first terminal and the terminal at the one end can be coupled together in a non-contact manner by simply allowing the first terminal to touch the insulating sheet and moving the first terminal together. Further, even if a circuit board is warped or otherwisemisaligned the distance required for the non-contact coupling can be maintained constant.

Yet another preferred embodiment of the circuit board testing apparatus is set forth in claim 3. Here, the insulating sheet is made of a material that allows easy sliding of the first terminal. Therefore, the first terminal can be smoothly moved in the touched condition with the insulating sheet.

Yet another preferred embodiment of the circuit board testing apparatus is set forth in claim 4. Here, the tip of the first terminal is shaped to allow easy sliding over the insulating sheet. Thus, the first terminal can be moved smoothly in the touched condition with the insulating sheet.

Yet another preferred embodiment of the circuit board testing apparatis is set forth in claim 5. Here, the test signal is made to be a signal having a rapid change. Therefore, a signal detected at the first terminal also rapidly changes in response to the change in the signal. Because wiring can thus be determined for continuity by detecting this rapid change testing can be conducted at high speed. Further, this brings about the advantage of being less subject to the effect of hums and other noises.

Yet another preferred embodiment of the circuit board testing apparatus is set forth in claim 6. Here, the determination means determines the wiring for continuity based on a maximum current generated between the test wiring and the first terminal after the specified signal has had a rapid change. The maximum current is generated almost simultaneously with the occurrence of the rapid change on the signal. Therefore, this allows the knowledge on the continuity condition of test wiring within an extremely short period of time.

Further, according to the present invention, there is also provided a circuit board testing method set forth in claim 7. When test wiring of the circuit board to be tested is formed with the first terminal being coupled in a non-contact condition to determine for continuity and short, the first terminal is moved over the surface on which the test wiring is formed, while maintaining the distance that allows non-contact coupling with the circuit board to be tested, until non-contact coupling of the first terminal is attained with one end of the next test wiring. Then a test signal is given to the test wiring that is non-contact coupled with the first terminal, to thereby determine the next test wiring of the circuit board to be tested for continuity and short based on the signal detected at the first terminal. Consequently this eliminates the need to move the first terminal in a direction to or away from the circuit board surface thus reducing testing time significantly. Further, because the continuity determination can be attained in a non-contact fashion with the terminal at the one end, no scratches or other damage are caused to the terminal at the one end.

Preferred embodiments of the present invention will now be described with respect to the enclosed drawings in which

Fig. 1 shows a schematic drawing of a board tester as one embodiment of the present invention;

Fig. 2 shows a plan view illustrating a circuit board to be tested;

Fig. 3 shows a plan view illustrating a structure of the heads shown in Fig. 1;

Fig. 4 shows a side view illustrating the structure of the head shown in Fig. 3;

Fig. 5A shows an enlarged view taken at Section Q in Fig. 4, and Figs. 5B and 5C show the tip shapes according to further embodiments of the present invention;

Fig. 6 shows a circuit configuration with respect to the signal processing according to the present invention;

Fig. 7 shows an equivalent circuit to describe the signal processing according to the present invention;

Fig. 8 shows a timing chart for signal processing;

Fig. 9 shows an equivalent circuit employing a sinusoidal wave AC measuring circuit;

Fig. 10 shows a timing chart for the sinusoidal wave AC measuring circuit during use;

Fig. 11 shows a timing chart for signal processing according to a further example of use;

Fig. 12 shows a further embodiment for the signal shapes; and

Fig. 13 shows a further embodiment of the board tester according to the present invention.

Throughout the specification to follow specific terms used therein are to be understood as outlined in the following.

The term "circuit board" refers to a base material on which wiring is formed and is not limited in terms of its material, structure, shape, or size. It includes, for example, glass epoxy substrates and film-like substrates as well as packages on which circuit elements such as CPUs are mounted. It further includes composite substrates wherein sockets are mounted on a glass epoxy substrate and substrates on which circuit elements are mounted.

The term "wiring" refers to a conductor that conducts electricity and is not limited in terms of its material, structure, shape, or size.

This is the concept that includes the conductive parts of printed patterns, through-holes, and pins formed in a circuit board, as well as those of electric cords, sockets, connectors, and pins attached to the circuit board.

The terms "one end of the wiring" and "the other end of the wiring" refer to the points of the wiring to and from which signals for tests are input and output, and these terms are not limited in terms of its material, structure, shape, or size. It includes the sections that form points of electrical contact with other parts, as found in printed pattern testing ends, connector connecting ends, connecting pins, pads for connecting bonding wires, pads for connecting circuit elements or sockets, insertion portions provided in sockets attached to circuit boards, and the input and output terminals of connectors, and also includes arbitrary locations in the wiring.

The term "non-contact coupling" refers to the coupling of two or more members in such a way that they can transmit and receive signals to and from one another while remaining insulated from one another. According to the present invention, this corresponds, e.g, to electrostatic coupling that uses electrostatic capacity but is not limited thereto.

The term "signal" refers to a signal used for testing. This is the concept that includes both voltage and current. Besides AC signals such as sine waves it includes DC signals, rectangular and triangular signals, and pulse-like signals.

The expression "based on the detection signal detected from the non-contact coupled test wire" means that something relates on the detection signal voltage itself or a physical quantity corresponding or relating to the voltage. Thus, the expression includes not only the voltage but also, e.g., a current corresponding or relating to the voltage and the related integral and differential values.

The term "detection of continuity of the wiring" is the concept that includes the detection of an open or short circuit of the wiring and the detection of the resistance value of the wiring such as the detection of a half-open-circuit.

The term "signal with a rapid change" refers to a signal with a large amount of variation in voltage or current per unit time, and includes, e.g., DC signals with a step-like rising or falling edge, triangular and rectangular signals, and pulse-like signals.

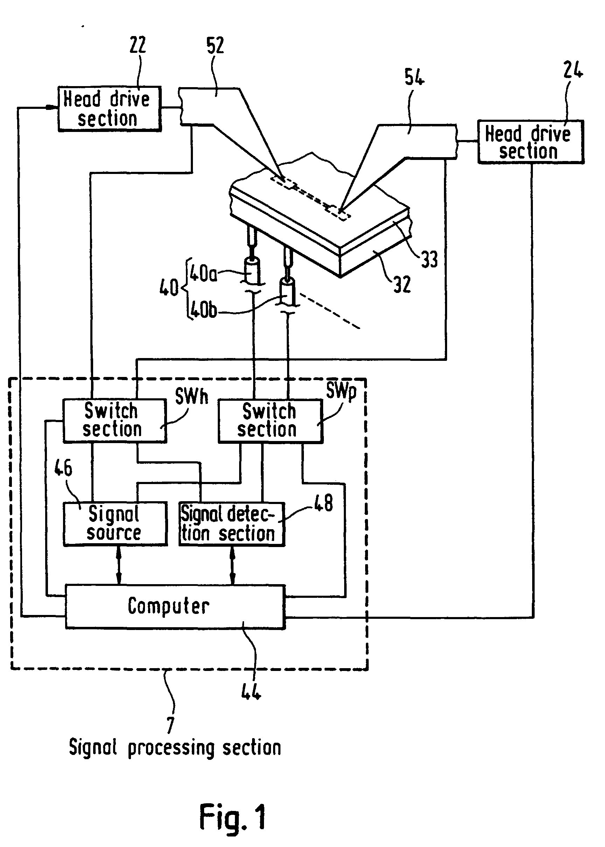

One embodiment of the present invention will now be described with reference to Fig. 1 showing the functional block diagram of a bare board tester 1 as a circuit board testing apparatus that utilizes electrostatic capacity. This bare board tester 1 is an apparatus that tests the continuity of a printed pattern on the printed circuit board (a bare board) on which no circuit elements have been mounted yet.

As shown in Fig. 1 the bare board tester 1 comprises a signal processing section 7, a probe section 40, head drive sections 22, 24, and heads 52, 54. In addition, the signal processing section 7 comprises switch sections SWp and SWh, a signal source 46, a signal detecting section 48, and a computer 44.

As will be discussed later in more detail, the heads 52, 54 are moved over the circuit board surface by means of the head drive sections 22, 24, respectively. A test signal that is output from the signal source 46 is supplied to the desired test wiring by the switch sections SWh, SWp. Further, the test signal supplied to the test wiring is detected at the head 52, the head 54 or the selected probe by means of the switch sections SWh, SWp. The detected test signal is subjected to a specified processing at the signal detecting section 48 shown in Fig. 1. Then the signal is supplied to the computer 44, which in turn checks each of the printed patterns that have been selected by the switch sections SWp, SWh, with respect to continuity and short.

As also shown in Fig. 1, the bare board tester 1 comprises a plurality of probes 40a, 40b, ... that are electrically connected to pads 36a, 36b, ... of the circuit board 32. The plurality of probes 40a, 40b, ... are collectively referred to as a probe section 40 with the following connected to the probe section 40 is the switch section SWp as first switching means. The switch section SWp is switched over in accordance with the switchover command from the computer 44 to thereby select the probe to be connected to the signal source 46 or the signal detecting section 48.

Further, over each pad of the pad section 38 on the circuit board 32 there may be positioned heads 52, 54 that can move in the X and Y directions in accordance with the MOVE command from the computer 44.

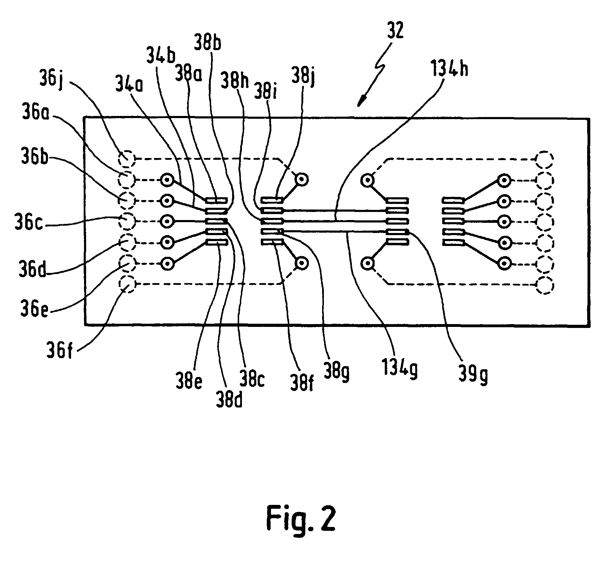

A printed circuit board to be tested will now be described with reference to Fig. 2.

As shown in Fig. 2, the embodiment uses a printed circuit board on which at one end thereof a printed pattern and pads are formed on the front surface, with pads at the other end thereof likewise being formed on the back surface.

Further, on the surface of the circuit board 32, there are formed a plurality of printed patterns 34a, 34b, ... as test wiring. The plurality of printed patterns 34a, 34b, ... are collectively referred to as a printed pattern section 34.

Still further, pads 36a, 36b, ... are formed on the back surface of the circuit board 32 at one end of the printed patterns 34a, 34b, ..., respectively. The pads 36a, 36b, ... are collectively referred to as a pad section 36. The pad section 36 is configured to be in a rough pattern to an extent that contact is attained with the probe section 40, as will be described later.

Still further, on the other end of each of the printed patterns 34a, 34b, ... there are formed additional pads 38a, 38b, ... respectively, which also are cllectively referred to a s a pad section 38. Because an IC chip is to be mounted on the pad section 38, the pitch at which each of the adjacent pads 38a, 38b, ... is disposed is very small, i.e. finely pitched for high density.

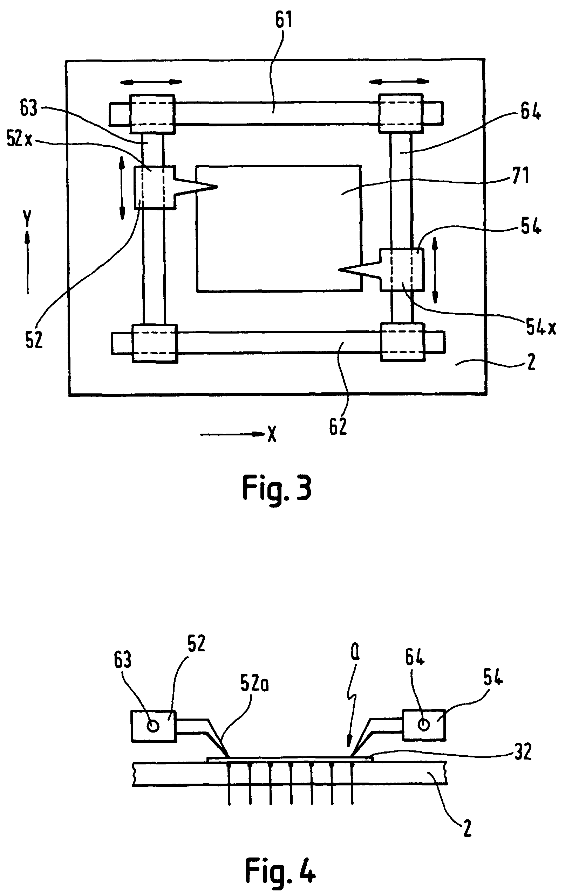

In the following, the heads 52, 54 will be described with reference to Figs. 3 and 4.

As shown in Figs. 3 and 4, a through-hole 52X is formed in the head 52 to allow a shaft 63 to go therethrough. Therefore, the head 52 can move in the Y direction along the shaft 63 or in the reverse direction by means of the head drive section 22 shown in Fig. 1. Through-holes are also formed in the shaft 63 to allow the shafts 61, 62 to go therethrough, so that the head 52 can also move in the X direction along the shafts 61, 62 or in the reverse direction. Thus, the head 52 can be positioned on the desired pad within the test area 71.

Likewise, the head 54 can move in the Y direction along the shaft 64 or in the reverse direction and this shaft 64 can also move in the X direction along the shafts 61, 62 or in the reverse direction.

As shown in Fig. 4, the tip 52a of the head 52 is positioned on the pad of the test circuit board 32 mounted on a circuit board holding plate 2.

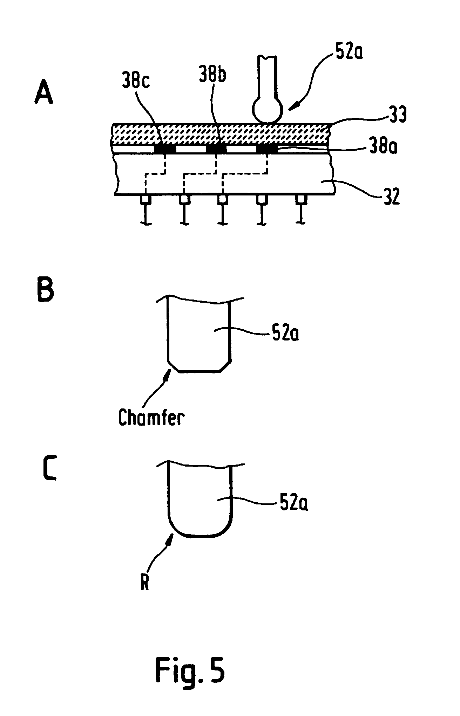

The relationship between the circuit board 32 and the tip 52a will now be described with reference to Fig. 5A.

According to this embodiment of the present invention the surface of the circuit board 32 is covered with an insulating sheet 33, which the tip 52a is made to touch. This allows a circtain distance which is equivalent to the thickness of said insulating sheet 33 to be maintained between each pad of the pad section 38 on the circuit board 32 and the tip 52a. Therefore, the relationship for a fixed capacity of electrostatic coupling is established even if the head 52 is moved along the X and Y directions.

Further, the insultaing sheet 33 is made of the material that allows the tip 52a of the head 52 to slide easily. Making the shape of the tip 52a spherical permitts smooth movement of the head 52 in the X and Y directions. However, the head shape is not limited to such "spherical" shape, but any shape is acceptable as far as smooth movement of the head 52 is attained in the X and Y directions, including for example a chamfered tip and a rounded tip as shown in Figs. 5B and 5C, respectively.

Further, according to this embodiment the heads 52, 54 correspond to the first terminal, and the probes 40a, 40b, ..., respectively, for contact to the second terminal. The probes 40a, 40b, ... contact the other end of test wiring coupled in a non-contact manner and supply a test signal.

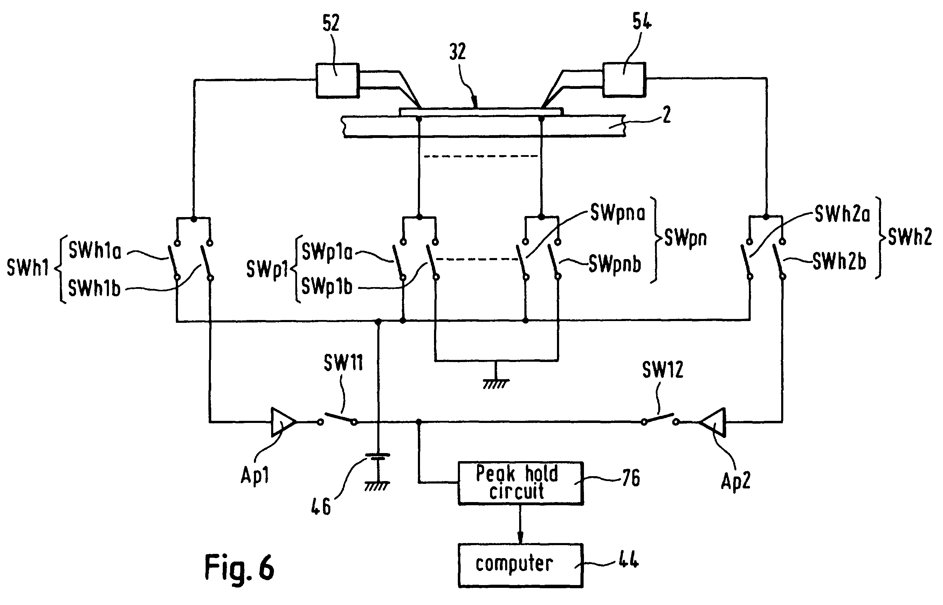

In the following, the switch sections shown in Fig. 1 will be described in further detail with reference to Fig. 6.

The switch section SWp that switches the probe section 40 comprises a plurality of swtiches SWp1, sWp2, ... as shown in Fig. 6. Each switch is turned on and off by the command from the computer 44 shown in Fig. 1 and transmits the signal supplied through the signal source 46, to the desired probe of the probe section 40. Further, the switch SWp1a is a selector switch for power supply and the switch SWp1b a selector switch on the return side.

As shown in Fig. 6, the head 52 is switched over the change the state of connection by means of the switch sections SWh1 and SW11. The switch SWh1a is a selector switch for power supply, and the switch SWh1b a switch for connecting to an amplifier. Further, the switch SW11 is a switch used to select an ampllifier to be connected to a peak hold circuit.

To check the pattern 34a, e.g., the pattern shown in Fig. 2, for continuity each of the switches is switched over. There, it is assumed that the switch in contact with the end pad 36a of the pattern 34a is the switch SWp1 shown in Fig. 6. First, turn on the switch SWh1b of the switch SWh1 and turn off the switch SWh1a. Further, turn on the switch SWl1, then the switch SWp1a, and turn off the switch SWp1b. This will apply the signal supplied from signal source 46 to the pad 36a, and the signal detected at the head 52 to the amplifier Ap1.

Further, like head 52 the head 54 can be switched over to change the state of connection by means of the switch sections SWh2 and SWl2.

Still further, when checking the pattern 134g shown in Figs. 2 for continuity, a continuity test will be conducted between the heads 52, 54. Therefore, apply the signal supplied from the signal source 46 to the head 54, then to a pad 39g, and switch over the switches SWh1, SWh2 shown in Fig. 6 in such a manner that the signal can be detected at the head 52. This may be achieved through, e.g., turning on the switch, SWh1b of the switch SWh1, turning off the switch SWh1a, turning on the switch SW11, turning off the switch SWh2b of the switch SWh2 and then turning on the switch SWh2a in the given order.

Reversely one may turn on the switch SWh2b of the switch SWh2, turn off the switch SWh2a, then turn off the switch SWh1b of the switch SWh1, turn on the switch SWh1a and turn on the switch SW12 in the given order.

Further, when checking the pattern 34a and the pattern 34b shown in Fig. 2 for shorting a shorting test is carried out between the pad 36a and the pad 36b. Therefore, the signal supplied from signal source 46 is applied to the pad 36a to thereby give a grouding potential to the pad 36b. In other words, if the switch in contact with the pad 36a is for example the switch SWp1 shown in Fig. 6, then one should turn on the switch SWp1a and turn off the switch SWp1b. Further, if the switch in contact with the pad 36b is the switch SWp2 shown in Fig. 6, then one should turn off the switch SWp2a and turn on the switch SWp1b.

Further, when the patterns 134g and 134h shown in Fig. 2 are to be checked for shorting a shorting test is conducted between the heads 52, 54. Therefore, e.g. the signal supplied from the signal source 46 is applied via the head 54 to the pad 134g, and the switches SWh1, SWh2 shown in Fig. 6 are switched over so that shorting can be detected from the head 52. In this case, one should turn on the switch SWh1b of the switch SWh1, turn off the switch SWh1a, turn on the switch SWl1, turn off the switch SWh2b of the switch SWh2, and then turn on the switch SWh2a in this sequence.

Next will be described the signal processing carried out by the signal source 46 and the signal detecting section 48 shown in Fig. 1.

This signal processing will be described on the basis that the pad 36a contacts the switch SWp1, the pad 36b contacts the switch SWp2, the pad 36c contacts the switch SWp3 and so on in the same manner (the pads being shown in Fig. 2) and with the head 52 moved to the pads 38a, 38b, 38c, ... one by one to sequentially check the patterns 34a, 34b, 34c, ... for continuity.

First, the computer 44 issues a drive command to the head drive section 22 shown in Fig. 1 to position the head 52 on the pad 38a. This allows the head 52 to touch the insulating sheet 33 and move onto the pad 38a whereby the head 52 is electrostatically coupled to the pad 38a.

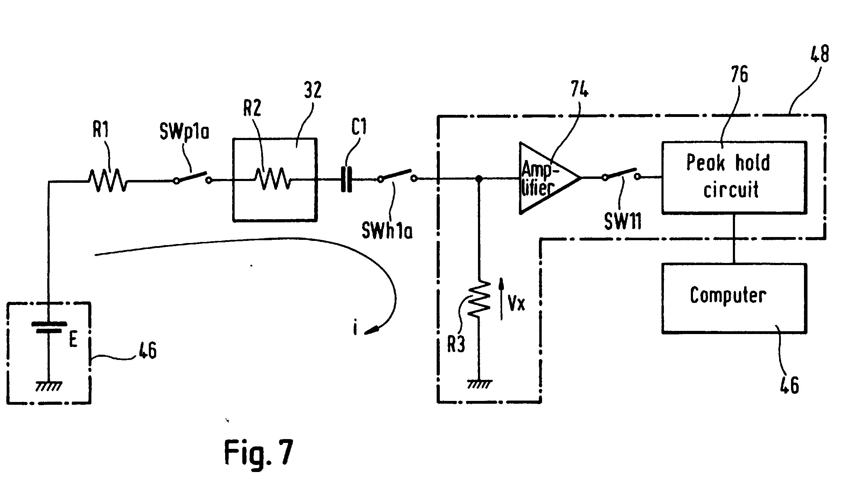

As a result, an equivalent circuit as shown in Fig. 7 is formed.

In Fig. 7 a resistor R1 represents the inner resistance of the switches SWp1a and SWh1b, and a resistor R2 represents the resistance of the printed pattern 34a on the circuit board 32, and a resistor R3 represents the grounding resistance of the signal detecting section 48, respectively. Further, an electorstatic capacitor C1 represents a capacitor formed by the tip 52a of the head 52, the insulating sheet 33 (see Fig. 5) and the pad 38a (see Fig. 5). A constant-voltage E represents a DC voltage of the signal source 46.

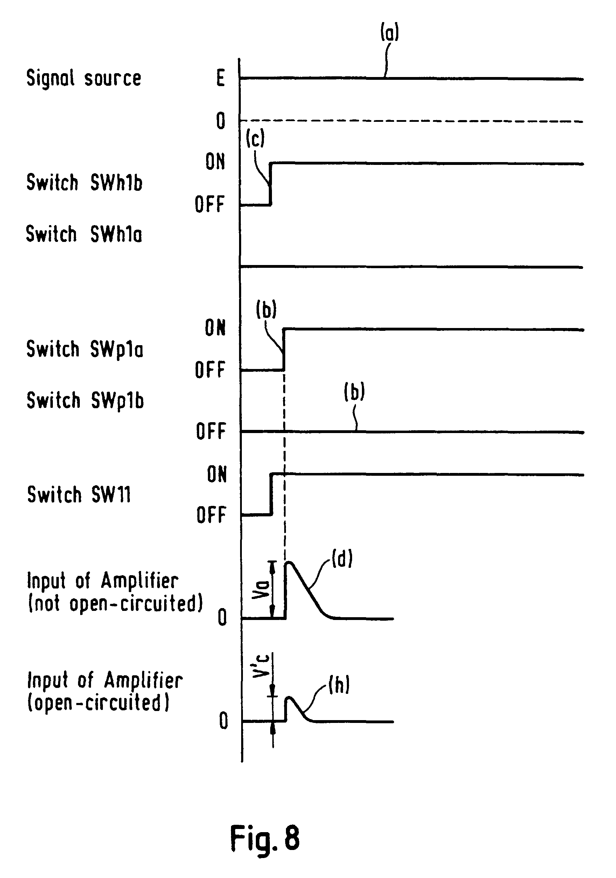

The switching-over timing of switches at the time of signal processing will be desdribed with reference to Fig. 8.

In Fig. 8, some of the switches configuring the switch sections SWp, SWh are left out for the sake of simpler description.

In the embodiment discussed so far, a constant-voltage source is used as a signal source 46. Therefore, a constant-voltage E is supplied from the signal source 46 (see Fig. 8 (a)) to the switch section SWp shown in Fig. 7. The computer 44 transmits the commands to the switch section SWh1 to turn on the switch SWh1b (see Fig. 8(c)), to turn off the switch SWh1a, and to turn on the switch SW11, respectively. The compuer 44 further transmits the commands to the switch section SWp to thereby turn on the switch SWp1a and turn off the switch SWp1b (see Fig. 6 and Fig. 8 (b)) accordingly.

With the switch SWp1a being turned on (see Fig. 8 (d)) the equivalent circuit shown in Fig. 7 closes causing the following current i to flow.

$$i = \{E/(R1+R2+R3)\} \cdot \exp(-\alpha t) \qquad (1)$$

$$\text{where: } \alpha = 1/\{(R1+R2+R3) \cdot C1\} \qquad (2)$$

Therefore, the input voltage Vx to the amplifier 745 is expressed by the following equation (3).

$$Vx = R3 \cdot i \qquad (3)$$

From Equations (1) and (3), the input voltage Vx to the amplifier 74 is expressed by the following equation (4).

$$Vx = \{R3 \cdot E/(R1+R2+R3)\} \cdot \exp(-\alpha t) \qquad (4)$$

$$\text{where } \alpha = 1/\{(R1+R2+R3) \cdot C1\}$$

The voltage Vx is amplified by the amplifier 74. Its maximum value (corresponding to the voltage Va in Fig. 8(d)) is then detected and held by a peak hold circuit 76. The peak hold circuit 76 is equipped with a D/A converter (not shown) and the dititized maximum value is transmitted to the computer 44. Equivalently, some of the functions of the peak hold circuit 76 can also be realized using the computer 44.

Based on the digitized maximum value the computer 44 determines the printed pattern 43a of the circuit board 32 for continuity. As seen from equation (4), the input voltage Vx to the amplifier 74 exhibits the maximum voltage Va (=R3 · E / (R1+R2+R3)) immediately after the switch SWp1a is turned on (see Fig. 8 (d)).

If the printed pattern 34a is found not open-circuited the input voltage Vx to the amplifier 74 will be the normal value as shown in Fig. 8(d). On the other hand, however, when the printed pattern 34a is actually open-circuited, the input voltage Vx to the amplifier 74 for the printed pattern 34a will be as shown in Fig. 8(h), resulting in the maximum value V'c being very small. This can also be understood from the fact that when in equation (2) R2 that represents the printed pattern resistance is infinitized (for complete open circuit) "Vx = 0" is always obtained irrespective of time t.

Therefore, a printed pattern can be easily determined for open circuit from whether or not the maximum value prevails, e.g., between the preset lower and upper reference values, thus enabling the detection processing of the maximum value by the peak hold circuit 76 to be completed in an extremely short period of time. This means that determination processing of a printed pattern for continuity can be conducted in an extremely short period of time. As a result, the detection signal is less subject to humming or other noise effects.

In the same manner as above, the computer 44 follows the testing program and continues to perform continuity tests on the printed patterns 34b, 34c, ... while moving the head 52 and switching over the respective switches of the switch sections SWp and SWh1 as appropriate.

Further, when testing the printed pattern 34b, the switch SWp1a may be turned off or may remain on.

Still further, in the embodiment described above, the head 52 is electrostatically coupled to the group of pads 38a, b ... by each independent capacitor. Therefore, the electrostatic capacity of an individual capacitor C1 becomes comparatively small. In other words, α shown in equation (1) becomes a relatively large value, namely, the time constant becomes small. This in turn reduces the time t required for the current i to be nearly zero allowing the determination processing of printed patterns for continuity to be done in an even shorter cycle.

Thus, in this embodiment the heads 52, 54 can be moved along the X and Y directions while maintaining the non-contact condition by the insulating sheet 33, namely without repeatedly moving the heads 52, 54 towards the circuit board, i.e. along the Z direction. This therefore enables printed patterns to be tested for continuity in a fast and exact manner.

This means that no use of an expensive and finely pitched probe is required even for a circuit board on which wiring to be tested is densely disposed at one end thereof, and that no possiblity of scratching said one end of the wiring is created, either.

Further, if the wiring is detected for continuity condition based on the voltage that is generated at the first terminal coupled to the other end of the wiring then one end of the wiring is connected or coupled. Thus, the wiring can be detected for continuity irrespective of the broken-wire position in the wiring or the presence of mutual wire shorting.

Furthermore, because the specified signal rapidly changes, the voltage generated at the first terminal when the signal is supplied also changes rapidly in response to the change in the signal. Therefore, detecting this rapid change enables to check the wiring for continuity, thus achieving fast testing. As a result, the detection signal is less subject to hums and other undesirable noises.

Further, coupling the first terminal to one end of the wiring and the second terminal to the other end of the wiring both in a non-contact manner also considerably reduces the coupling capacity as compared with coupling only the first terminal to the wiring in a non-contact manner. This in turn reduces the time constant of the circuit to which a signal current runs at the time of testing allowing the testing time to be further reduced.

The present invention thus allows an inexpensive and yet highly reliable test to be done in a short period of time even for a denselywired circuit board.

Further, while in the above there has been described an apparatus as embodiment of the present invention which moves the heads 52, 54 in parallel in the X and Y directions to the desired positions the present invention is not limited to this aspect. Any head drive that can move the heads to the desired positions is acceptable. For example, an apparatus in which the head(s) can move to the desired position(s) by rotating on the X-Y plane about the axis may be accepted.

Further, the apparatus according to the presentin invention can also be configured in such a manner that the switch SWp1a is turned off immediately after the maximum value detection processing (processing for detecting the maximum value corresponding to the voltage Va) of the printed pattern 34a by the peak hold circuit 76 is completed, and that the head 52 is moved, followed by the switch SWp2a being turned on. Configuring the embodiment in this manner enables to move on to the test of a next printed pattern 34b without waiting for the curent i running into the printed pattern 34a to be nearly zero. Consequently, this allows a printed pattern to be tested for continuity in an even shorter cycle. Furthermore, with the this configuration implemented the test cycle will never become extremely long even if the time constant (reciprocal number of $\alpha$ in equations (1), (2)) is large.

Further, the embodiment has been described in conjunction with the signal having a rapid change as a specified signal for use in testing. However, the present invention is not limited to this aspect. As a specified signal for use in testing one can also use an AC signal such as an sinusoidal wave alternating current, as will be described in the following.

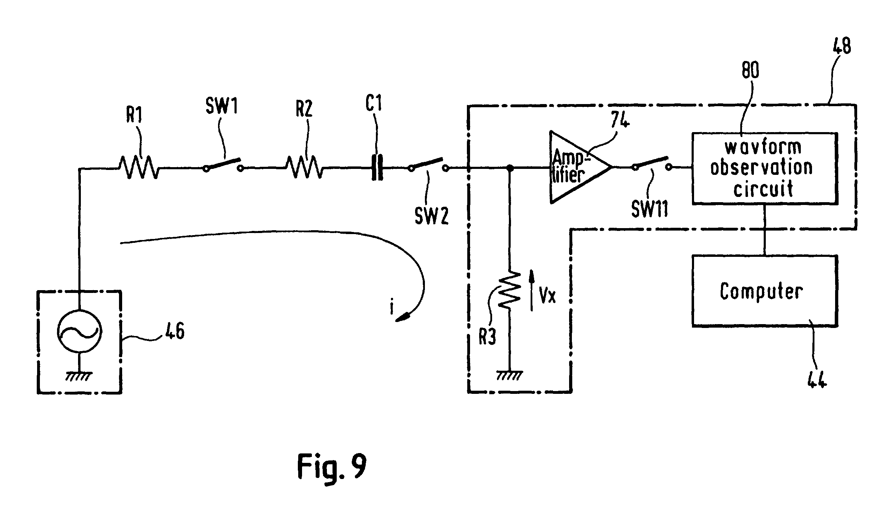

When using an AC signal as a specified signal, e.g., a sinusoidal wave oscillator as shown in Fig. 9 may be used.

In this case as a signal source 46, a sinusoidal wave having a frequency of some 10 kHz is generated at the signal source 46. Further, as an element configuring a signal detecting section 48 a waveform observation circuit 80 may be used instead of the peak hold circuit 76 shown in Fig. 7. The waveform observation circuit 80 is a circuit that processes the input signal and evaluates the signal level and waveform thereof. Specifically, e.g., a wave detection circuit and an oscilloscope are used for this purpose.

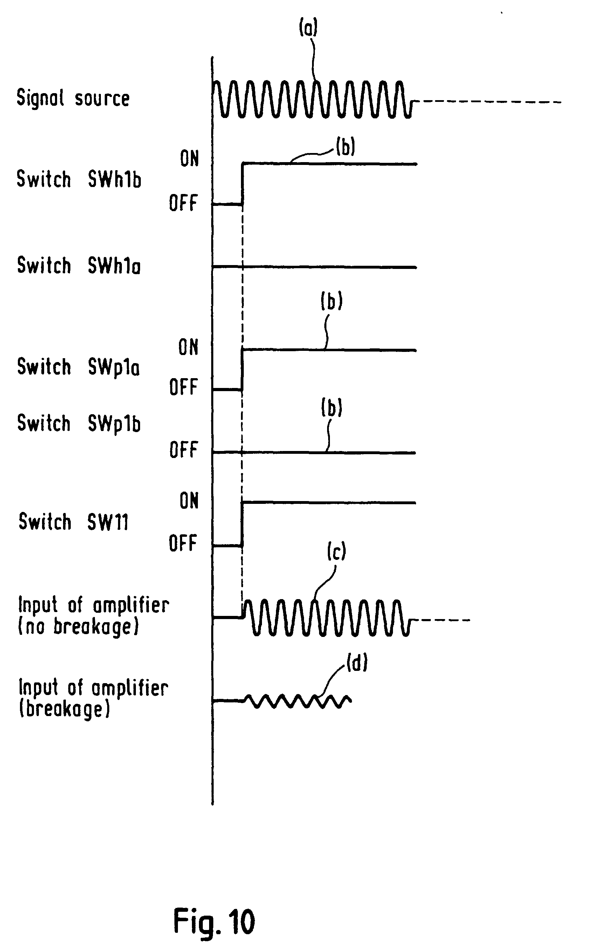

As shown in Fig. 10, in this case the computer 44 supplies the sinusoidal wave (see Fig. 10 (a)) generated in the signal source 46 to the printed pattern to be tested by switching over each switch of the switch sections SW1 and SWh (see Fig. 10 (b)). The computer 44 also determines each printed pattern for continuity based on the data that have been obtained through the signal detecting section 48.

When a specific printed pattern has been determined to be free from wire breakage the input voltage Vx supplied to the amplifier 74 will show a normal value as shown in Fig. 10 (c). On the other hand, however, if the printed pattern has a wire breakage the input voltage Vx supplied to the amplifier 74 will have a smaller value than that shown in Fig. 10 (c) above, see Fig. 10 (d). In other words, when the printed pattern is actually open-circuit the input level will be extremely small thus making it easy to determine the continuity.

Further, when using such an AC signal as outlined above the increase in test efficiency is reduced in comparison to the embodiment in which a signal with a rapid change is used. However, employing such an AC signal allows an aparatus to be configured using a sinusoidal wave oscillator and a wave detection circuit that are relatively commonly utilized in non-contact type test apparatuses. Therefore, one can expect a shorter delivery time as well as a reduction in apparatus design and production costs that is attained by diverting existing parts for a specific application.

Further, in the embodiment according to Fig. 8 a constant-voltage source is used as a signal source 46 (see Fig. 8 (a)), and a DC voltage supplied from the signal source is configured so that a step-like test signal with a sharp rising edge is obtained by turning on and off each switch of the switch section (see Fig. 8(c)). However, as a signal source 46 also a signal generator that sequentially generates signals having rapid changes may be used.

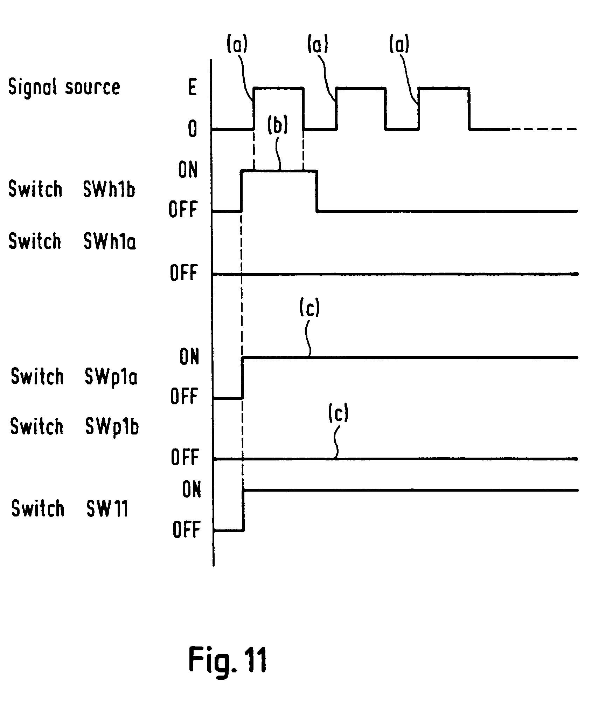

Fig. 11 shows a timing chart with respect to the signal processing executed when such a modified signal source 46 is used. As is shown in Fig.11, the signal source 46 is configured to generate a rectangular wave. Therefore, in this example a rectangular wave generation circuit is used as the signal source 46. The computer 44 may distribute each rectuangular wave signal that is sequentially generated by the signal source 46 to each printed pattern 34a, 34b, ... (see Fig. 1) by switching over each switch of the switch sections SWp and SWh (see Fig. 11(b), (c)) almost in synchronization with the phase of the rising edge of each rectangular signal generated by the signal source 46 (see Fig. 11(a)). The input voltage Vx supplied to the amplifier 74 and the processing after the input to the amplifier 74 are the same as for the example shown in Fig. 7.

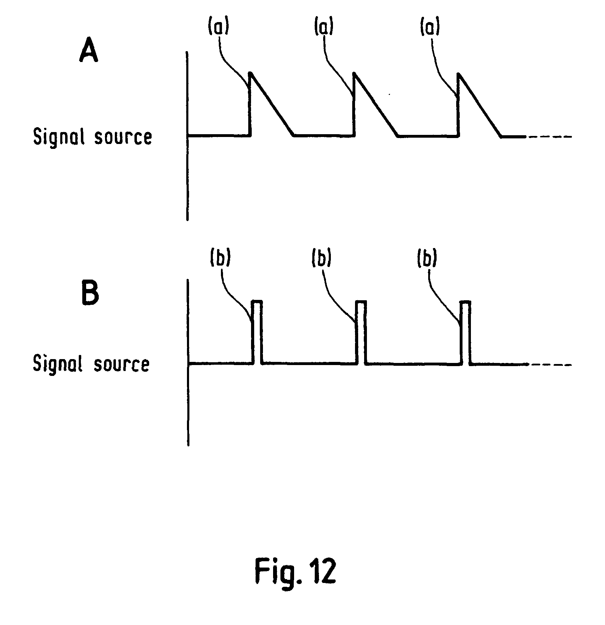

As shown in Fig. 12 the signal source 46 may also be configured to generate a triangular wave (see Fig. 12A). According to Fig. 12A each triangular signal has a sharp rising edge (a). Furthermore, as shown in Fig. 12B the signal source 46 may also be configured to generate a pulse train. Similarly to Fig. 12A, each pulse signal has a sharp rising edge (b) in Fig. 12B.

Signals with a sharp rising edge are not limited to those described above. In addition to signals rising at time 0 there may be included signals rising over some time as well as signals having a sharp falling edge.

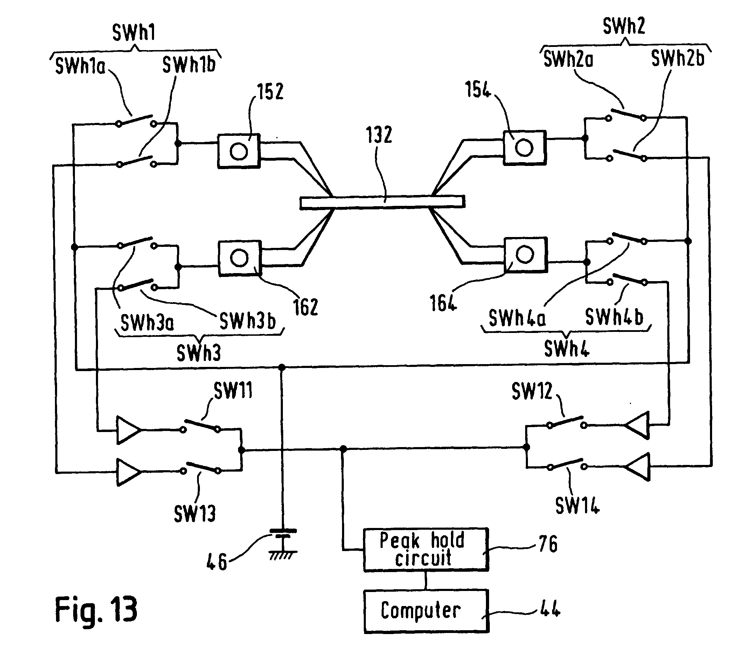

In the following a further embodiment adapted to double-sided testing will be explained with reference to Fig. 13.

In the embodiment illustrated in Fig. 13 there is provided a circuit board 132 on both sides finely pitched pads are formed. Here, confinuity testing is enabled through a testing apparatus 100 that has heads 152, 154, 162, 164 on both surfaces of said circuit board 132.

Generally, the embodiments outlined above are configured to determine the wiring for continuity based on the maximum current generated at the first terminal after a rapid change occurs on the signal. But the present invention is not limited to this aspect. The embodiments may be configured to determine the wiring for continuity based on, e.g., the quantity relating to the current that is generated between the first terminal and one end of the wiring when a signal with a rapid change is supplied to the other end of the wiring; these quantities include the average value of the current generated between the first termnal and one end of the wiring within the specified time further, the current value after the specified time, the steady-state deviation current and the integral value of the current flowing between the first terminal and one end of the wiring after the signal has had a rapid change. However, configuring the present invention to determine the wiring for continuity based on the maximum current allows a continuity test to be performed in a shorter period of time.

Further, some or all of the functions of the computer 44 shown in Fig. 1 may be realized using a hardware logic. Still further some or all of the functions of the signal source 46 or of the signal detecting section 48 may be realized using a computer.

Additionally, according to the different embodiments the second terminal is configured to be coupled to the other end of the wiring to be tested by means of electrostatic capacity. As a result, a highly reliable test may be carried out using a simple configuration.

Further, in the embodiments the first terminal is configured to be connected to one end of the wiring to be tested and may also be configured to be coupled to one end of the wiring, e.g. by electrostatic capacity.

Further, the embodiments have been described in conjunction with the circuit board to be tested, which has a plurality of other ends mutually connected. However, the present invention is not limited to testing such a circuit board.

Further, although the embodiments have been described in conjunction with a bare board tester as an example, the present invention is not limited to such a bare board tester and may be applied to printed circuit board testing apparatuses in general as well as the printed circuit board test methods in general including those testing apparatuses for circuit boards on which CPUs and other circuit elements are mounted and for packages used to mount circuit elements.

Further, by proving a signal source that generates a DC signal and switching over the first switching means sequentially the embodiments may be configured to obtain a signal having the rapid change from the DC signal generated by the signal source and also to sequentially determine the wiring specified by the first terminal selected, for continuity using the obtained signal.

**Claims**

1. Circuit board testing apparatus comprising:

    a) a first terminal (52a) that is to be coupled in a non-contact manner to either end (36, 38) of test wiring (34) of a circuit board (34) to be tested;

    b) a transfer means (22, 24) that transfers the first terminal (52a) over the surface on which the test wiring (34) of the circuit board (34) to be tested is formed, while maintaining the non-contact condition;

    c) a test signal supply means (46) that supplies a test signal to the other end of said non-contact coupled test wiring; and

    d) determination means (44) for determining test wiring of a circuit board to be tested, for continuity and short based on a detection signal that is detected from the non-contact coupled test wiring (34).

2. Circuit board testing apparatus according to claim 1, characterized in that an insulating sheet (33) is provided between the first terminal (52a) and the curcit board (33) to be tested.

3. Circuit board testing apparatus according to claims 2, characterized in that the insulating sheet (33) is made of material that provides the first terminal (52a) with excellent sliding characteristics.

4. Circuit board testing apparatus according to claim 2 characterized in that the tip of the first termianl (52a) is shaped to provide excellent sliding characteristics over the insulating sheet (c, R).

5. Circuit board testing apparatus according to claim 1, characterized in that the test signal is provided to rapidly change.

6. Circuit board testing apparatus according to claim 5, characterized in that the determination means (44) determines the wiring for continuity based on the maximum current generated between the test wiring (34) and the first terminal (52a) after a rapid change has occurred on the test signal.

7. Circuit board testing method, wherein when test wiring (34) of a circuit board (32) to be tested to which a first terminal (52a) is coupled in a non-contact manner is formed for continuity and short determination,

   a) the first terinal (52a) is transferred over the surface on which the test wiring (34) is formed while it is kept away at a distance that allows non-contact coupling to the circuit board (32),

   b) a test signal is supplied to the test wiring that is coupled with the first terminal (52a) in a non-contact manner; and

   c) test wiring of circuit board to be tested is determined for conitnuity and short based on the signal detected at the first terminal (52a).

8. Circuit board testing method according to claim 7, characterized in that it further comprises the step of repeating steps a) to c) for each of a plurality of test wirings (34) formed on a circuit board (32) to be tested.

| | 22 | | 52 | | 54 | | 24 | |

Head drive section

Head drive section

33

32

40 { 40a / 40b

SWh

Switch section

SWp

Switch section

46

Signal source

Signal detection section

48

Computer

7

44

Signal processing section

Fig. 1

Fig. 2

Fig. 3

Fig. 4

A

38c    38b                    52a

33

38a

32

B

52a

Chamfer

C

52a

R

# Fig. 5

Fig. 6

Fig. 7

EP 0 919 820 A2

Fig. 8

Fig. 9

Fig. 10

Fig. 11

Fig. 12

Fig. 13

EP 0 919 820 A2